# EUROPEAN PATENT APPLICATION

(11) **EP 1 511 089 A2**
(43) Date of publication of application: **02.03.2005**
(21) Application number: 04019511.7
(22) Date of filing: 17.08.2004
(51) Int. Cl.: H01L 33/00

(54) **White-light emitting device, and phosphor and method of its manufacture**

(30) Priority: 27.08.2003 JP 2003303210
(71) Applicant: SUMITOMO ELECTRIC INDUSTRIES, Ltd, Osaka-shi, Osaka 541-0041 (JP)
(72) Inventor: Fujiwara, Shinsuke, Itami Works, Itami-shi Hyogo (JP)
(74) Representative: Grünecker, Kinkeldey, Stockmair & Schwanhäusser Anwaltssozietät

(57) **Abstract**

White-light emitting device that excels in emission efficiency and temperature stability and that can put out white light of a color temperature of choice is afforded by utilizing phosphors of superior temperature characteristics and high light-emitting efficiency; the phosphors and a method of manufacturing the phosphors are also made available. An LED (1), and a phosphor (3) ZnS_{*x*},Se_{*1-x*}(0 < *x* < 1) that contains at least one activator among Cu, Ag and Au and that, excited by light irradiated from the LED, produces light are furnished.

## Description

### BACKGROUND OF THE INVENTION

### Field of the Invention

The present invention relates to white-light emitting devices, phosphors utilized in the devices, and to methods of manufacturing the phosphors.

### Description of the Background Art

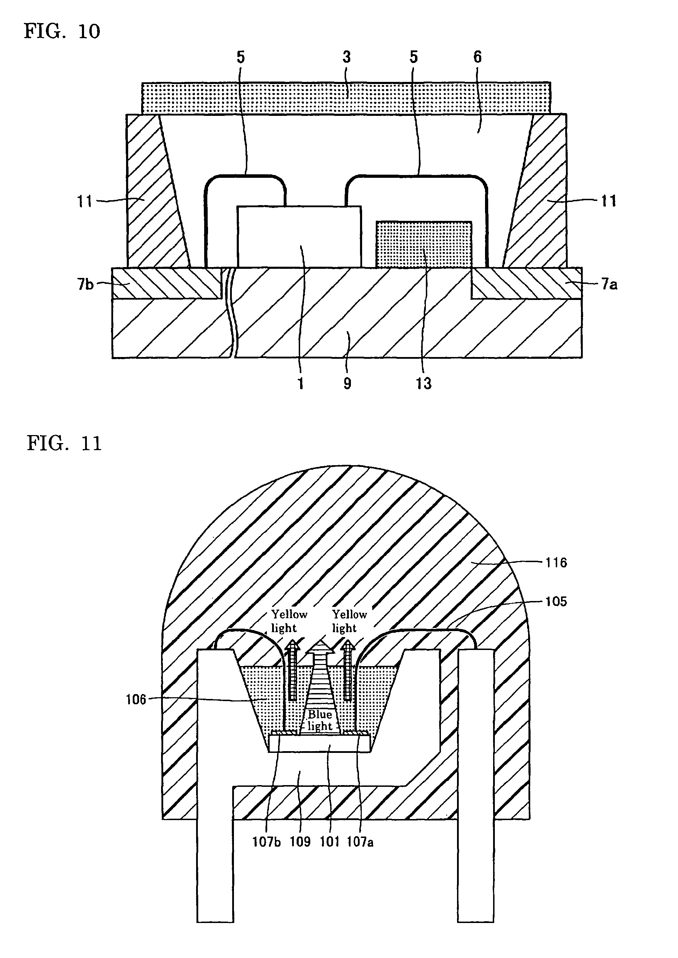

Reference is made to Fig. 11, a view depicting an example of a conventional white-light emitting device. (See for example Optically Active Materials Manual Managing Editorial Group, Eds., "Optically Active Materials Manual," The Optronics Co., Ltd., June 1997.) In Fig. 11, surrounding an InGaAs blue LED 101 disposed in the mounting portion 109 of a lead frame is an encompassing synthetic-polymer casting 106 in which a YAG (yttrium-aluminum-garnet) phosphor is dispersed. A molded synthetic-polymer seal 116 seals the casting 106, metal wires 105, and the lead frame. Through the wires 105 out of separated respective portions of the lead frame, voltage is applied across two electrodes 107a and 107b, and current flows into the blue LED 101 to give rise to a blue-light emission. A portion of the blue light is used to excite the YAG phosphor and generate yellow light, and by combining the yellow light and the blue light, white light is realized. Herein, a YAG phosphor activated with cerium is employed. Employing light of 460 nm as the blue light, with the spectrum of the converted yellow light centering on about 570 nm, a device that emits white light at a color temperature on the order of 7000 K is realized.

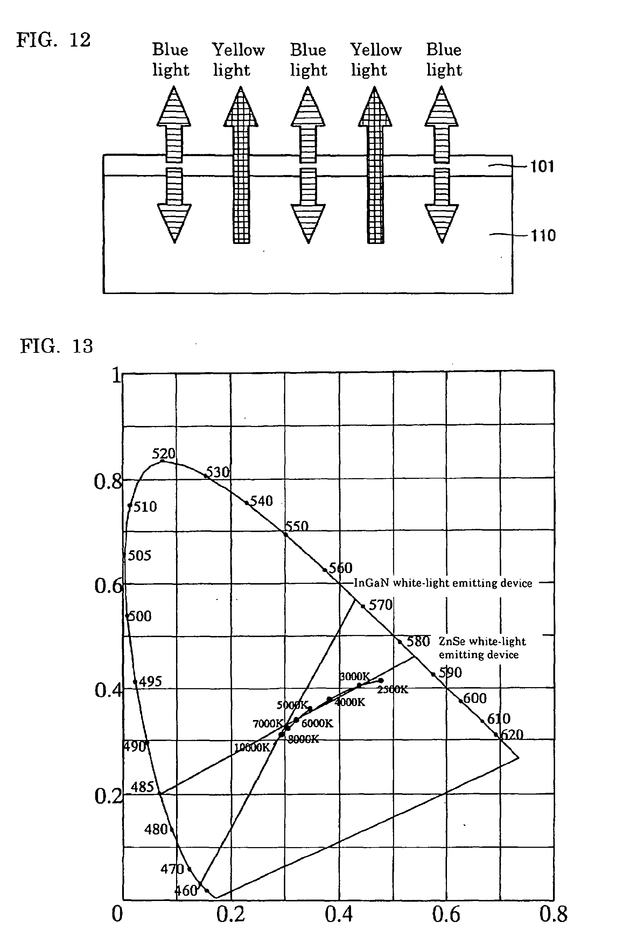

Meanwhile, a method of producing white light by converting a portion of blue light from, as represented in Fig. 12, a blue LED 101 of the ZnCdSe type in which a ZnSe substrate 110 is employed, into yellow light by means of the ZnSe substrate, which contains fluorescing impurities or defects, has been proposed. (See Japanese Unexamined Pat. App. Pub. No. 2000-150961.) This method employs blue light of 485 nm and yellow light whose spectrum centers on 585 nm to realize white light at a color temperature of choice from 10,000 K to 2,500 K. In addition, as a cross between these two methods, a method of producing white light by converting a portion of blue light from an InGaN blue LED into yellow light using a ZnSe phosphor has also been proposed. (See Japanese Unexamined Pat. App. Pub. No. 2000-261034.)

If the synthesis of colors in the conventional white-light emitting devices described above is examined in a chromaticity diagram as in Fig. 13, with the ZnSe white-light emitting device, the locus for white light, and the tie line joining the LED blue light and substrate emission roughly coincide. Therefore, simply by varying the proportions of blue light and yellow light, white light of a color temperature of choice can be produced. Nevertheless, a drawback with ZnSe LEDs is that they have a short lifespan because they are prone to deterioration.

With InGaN white-light emitting devices on the other hand, as will be understood from Fig. 13, the tie line joining the blue light and yellow light is at an incline with respect to the locus for white. This means that white light of a color temperature of choice cannot be synthesized, and in particular is prohibitive of synthesizing white light of color temperature lower than the proximity of 5000 K. In general, because the color temperature of white electric-light bulbs is a low 3500 K or thereabouts, with InGaN white-light emitting devices white light of the same color temperature as with white light bulbs cannot be realized and only white light of color temperature differing from that of white light bulbs is feasible. Consequently, white light bulb replacements by means of InGaN white-light emitting devices, despite having superior lifespan and efficiency characteristics, have not made sufficient progress.

In the case of the method by which white light is produced by converting a portion of the blue light from an InGaN blue LED into yellow light by means of, for example, a ZnSe phosphor, employing a blue LED whose emission wavelength is in the proximity of 485 nm resolves the foregoing problem. As will be demonstrated in detail later, however, as a phosphor the conversion efficiency of ZnSe is not high and its temperature characteristics are not satisfactory. Consequently, superior white-light sources are not practicable in cases in which ZnSe is utilized.

The white LEDs in any of the foregoing cases synthesize white by mixing together blue light and yellow or yellow-green light. Nevertheless, because green light and red light are deficient in these cases, one would be hard-pressed to suggest that the LEDs would be an ideal illuminant as a backlight for color liquid crystal displays or a light source in lighting applications. Given the circumstances, with the aim of achieving white LEDs in which three primary colors, red-green-blue, are blended, at present the development of methods that employ ultraviolet-light-emitting LEDs to blend fluorescence of three kinds is intensively underway. One roadblock, however, is that because the emission efficiency of ultraviolet LEDs is lower than the efficiency of blue light LEDs the efficiency with which white light is emitted ends up being as a consequence low.

### SUMMARY OF THE INVENTION

An object of the present invention is by utilizing phosphors of superior temperature characteristics and high light-emitting efficiency to afford a white-light emitting device that excels in emission efficiency and temperature stability and that can produce white light of a color temperature of choice, and to make available the phosphors and a method of manufacturing the phosphors.

A white-light emitting device in one aspect of the present invention is furnished with: an LED; and a phosphor ZnS_{*x*}Se_{*1-x*} (0 < *x* < 1) that contains at least one activating agent (activator) among Cu, Ag and Au and that, stimulated by rays irradiated from the LED, sends forth light.

This configuration provides for constructing a white-light emitting device whose temperature characteristics are stable and that utilizes a phosphor of high emission efficiency, which thus allows high-efficiency white-light emitting devices whose hue does not alter from long-term use to be achieved.

The abovementioned phosphor may be ZnS_{*x*}Se_{*1-x*} (0.2 ≤ *x ≤* 0.9), and may be rendered so that, stimulated by rays in a range of wavelengths 380 nm to 500 nm irradiated from the LED, the phosphor sends forth light.

By combining a blue LED and a phosphor that produces fluorescence of wavelength longer than that from the LED, this configuration enables a white-light emitting device of stabilized hue to be achieved.

The foregoing phosphor ZnS_{*x*}Se_{*1-x*} (0 < *x* < 1) further may contain at least one coactivator among Cl, Br, I, Al, In and Ga.

Utilizing the coactivator allows the light-emission efficiency to be heightened further.

The foregoing phosphor ZnS_{*x*}Se_{*1-x*} (0 < *x* < 1) may be in either a clumplike or powdered form.

Although phosphor usage methods that incorporate it as a powder into a synthetic polymer are well-known ways of employing the material, if it is in clump form, temperature elevation can be kept under control since heat generated within the phosphor is readily given off to the exterior.

A foregoing phosphor ZnS_{*x*}Se_{*1-x*} (0.5 ≤ *x* ≤ 0.9) may contain at least one of the activators Au and Cu, and be rendered so that, stimulated by rays in a range of wavelengths 410 nm to 490 nm irradiated from the LED, the phosphor sends forth light.

The configuration just noted, given that at least one of Au and Cu is employed for the activator, viewed in terms of efficiency enables the optimal combination of the two fluorescers that are components of the white-light emitting device to be achieved.

An aforementioned phosphor ZnS_{*x*}Se_{*1*}₋_{*x*} (0.4 ≤ *x* ≤ 0.5) may contain the activator Ag and, stimulated by rays in a range of wavelengths 410 nm to 490 nm irradiated from the LED, sends forth light.

This configuration, viewed in terms of efficiency given that Ag is employed for the activator, enables an optimal combination constituting the white-light emitting device to be formed.

A white-light emitting device in another aspect of the invention may include, as the phosphor ZnS_{*x*}Se_{*1-x*} (0 < *x* < 1), at least one of a phosphor Zn*S*_{*x*}Se_{*1-x*} (0.7 ≤ *x* ≤ 0.9) containing at least one of the activators Au and Cu, and a phosphor ZnS_{*x*}Se_{*1-x*} (0.5 ≤ *x* ≤ 0.8) containing the activator Ag, and may be furnished with an LED that irradiates light in a range of wavelengths 410 nm to 490 nm, and a separate LED that irradiates red light.

According to this configuration, an RGB white-light emitting device can be constituted with the green (G) role being taken on by either of the phosphors just noted, and with a blue LED and a red LED. With red light therefore also being included, white light that for all applications is trouble-free can be made available.

A white-light emitting device in a further aspect of the present invention may include as the phosphor ZnS_{*x*}Se_{*1-x*} (0 < *x* < 1), at least one of a phosphor ZnS_{*x*}Se_{*1-x*} (0.7 ≤ *x* ≤ 0.9) containing at least one of the activators Au and Cu, and a phosphor ZnS_{*x*}Se_{*1-x*} (0.5 ≤ *x* ≤ 0.8) containing the activator Ag, and be additionally furnished with a separate phosphor that sends forth light of wavelength longer than that from the phosphor just noted, and may be rendered so that, stimulated by rays in a range of wavelengths 410 nm to 490 nm irradiated from an LED, both the phosphors send forth light.

According to this configuration, with the green light (G) and red light (R) roles being taken on by phosphors of two kinds, and brought together with blue light (B) from a blue LED, white light utilizable in all applications, including as a backlight for a liquid-crystal display, can be created.

A white-light emitting device in yet another aspect may include as the phosphor ZnS_{*x*}Se_{*1-x*} (0 < *x* < 1), at least one of a phosphor ZnS_{*x*}Se_{*1-x*}(0.7 ≤ *x* ≤ 0.9) containing at least one of the activators Au and Cu, and a phosphor ZnS_{*x*}Se_{*1-x*} (0.5 ≤ *x* ≤ 0.8) containing the activator Ag, and additionally be furnished with, as a separate phosphor, ZnS_{*x*}Se_{*1-x*} (0.2 *≤ x ≤* 0.4) containing at least one of the activators Au and Cu, and may be rendered so that, stimulated by rays in a range of wavelengths 410 nm to 490 nm irradiated from an LED, both the phosphors send forth light.

According to this configuration, the red-light and green-light roles are taken on by ZnSSe phosphors and are brought together with blue light from a blue LED, wherein an RGB type of white-light emitting device applicable to any use whatever can be formed.

In an additional aspect of the present invention a white-light emitting device may be furnished with, as the phosphor ZnS_{*x*}Se_{*1-x*} (0 < *x* < 1), a phosphor ZnS_{*x*}Se_{*1-x*} (0.2 ≤ *x ≤* 0.4) containing at least one of the activators Au and Cu, and also be furnished with a separate phosphor that sends forth green light, and may be rendered so that, stimulated by rays in a range of wavelengths 410 nm to 490 nm irradiated from an LED, both the phosphors send forth light.

This configuration brings together red-light whose role is taken on by the phosphor ZnS_{*x*}Se_{*1-x*} (0.2 ≤ *x* ≤ 0.4) and green light that is allotted to another suitable phosphor with blue light from a blue LED to enable an RGB white-light emitting device to be formed.

The phosphor ZnS_{*x*}Se_{*1-x*} (0 < *x <* 1) may be in clumplike form, and may be mounted on, so as to mate surfaces with, either the blue LED or a heat-dissipating member furnished in the white-light emitting device.

With a clumplike phosphor, heat arising in the interior is readily transmitted to the phosphor surface; mounting the phosphor as just mentioned on either a heat-dissipating member or the blue LED so that the mounting surfaces mate facilitates letting the heat escape.

An InGaN LED may be utilized for the foregoing blue LED. That makeup provides for a stable, low-cost blue LED, which contributes to achieving a highly reliable white-light emitting device.

It is preferable that the foregoing phosphors ZnS_{*x*}Se_{*1-x*} (0 < *x* < 1) be heat-treated in an atmosphere containing Zn vapor.

Through a technique of this sort phosphors of high fluorescing efficiency can be achieved.

A phosphor-manufacturing method of the present invention includes: a step of forming a phosphor ZnS_{*x*}Se_{*1-x*} (0 < *x* < 1) containing at least one among coactivators Cl, Br, I, Al, In and Ga; and a step of carrying out a process, within a vaporous mixture of a vapor of at least one of activators Au, Cu and Ag and a vapor of Zn, of heating the coactivator-containing phosphor ZnS_{*x*}Se_{*1-x*} (0 < *x* < 1) to the vaporous mixture temperature.

This method yields a phosphor ZuS_{*x*}Se_{*1-x*} (0 < *x <* 1) of high light-emission efficiency, containing activators and coactivators.

A white-light emitting device of the present invention, by utilizing fluorescing materials such as phosphors, makes it possible stably to produce, with good efficiency and without altering of hue relative to changes in temperature, white light of a color temperature of choice.

From the following detailed description in conjunction with the accompanying drawings, the foregoing and other objects, features, aspects and advantages of the present invention will become readily apparent to those skilled in the art.

### BRIEF DESCRIPTION OF THE DRAWINGS

Fig. 1 is a chart showing that in embodying the present invention the temperature dependence of ZnSe phosphor is significant;
Fig. 2 is diagram illustrating basic thinking in the development of the phosphors ZnS_{*x*}Se_{*1-x*} in embodying the present invention;
Fig. 3 is a diagram showing fluorescence spectra for ZnSSe in which the activator Cu is utilized;
Fig. 4 is a diagram showing fluorescence spectra for ZnSSe in which the activator Ag is utilized;
Fig. 5 is a chromaticity diagram plotting the spectral peaks for ZnSSe in which the activator Cu is utilized and in which Ag is;
Fig. 6 is a chart showing the dependence of spectral peak on S atomic fraction, for ZnSSe in which the activator Cu is utilized and in which Ag is;
Fig. 7 is a chart illustrating the temperature dependence of the fluorescent intensity of ZnSSe in which the activator Cu is utilized;
Fig. 8 is a chart illustrating the temperature dependence of the fluorescent intensity of ZnSSe in which the activator Ag is utilized;
Fig. 9 is a view illustrating the configuration of a white-light emitting device of Embodiment 1 of the present invention;
Fig. 10 is a view depicting the configuration of a white-light emitting device of Embodiment 2 of the present invention;
Fig. 11 is a view showing the configuration of a conventional white-light emitting device;
Fig. 12 is a view representing the configuration of another conventional white-light emitting device; and
Fig. 13 is a chromaticity diagram plotting color data for conventional white-light emitting devices.

### DETAILED DESCRIPTION OF THE INVENTION

Next, using the drawings, an explanation of embodiments of the present invention will be made.

### Basic Concept of the Invention

In developing phosphors, crucial characteristics are the excitation-emission properties, and the emission efficiency. As far as the excitation-emission properties are concerned, in instances in which blue LEDs, which have seen significant advances in recent years, are employed as an optical excitation source the phosphors must be efficiently stimulated by blue light and exhibit fluorescence in yellow, which is blue's complementary color. If white LEDs of the RGB type are to be manufactured, then it is necessary for the phosphors to express by blue light red and green fluorescence. The emission efficiency of a phosphor can be evaluated according to the dependence of its fluorescent intensity on temperature. In general, at low temperature phosphors have high emission efficiency, while their fluorescing efficiency drops with elevations in temperature. However, to what extent can the temperature be raised before the efficiency drops differs depending on the kind of phosphor. Accordingly, if the fluorescence efficiency of a phosphor does not vary from low temperature to the temperature zone in which phosphors are employed, then its temperature characteristics are satisfactory and its emission efficiency is high.

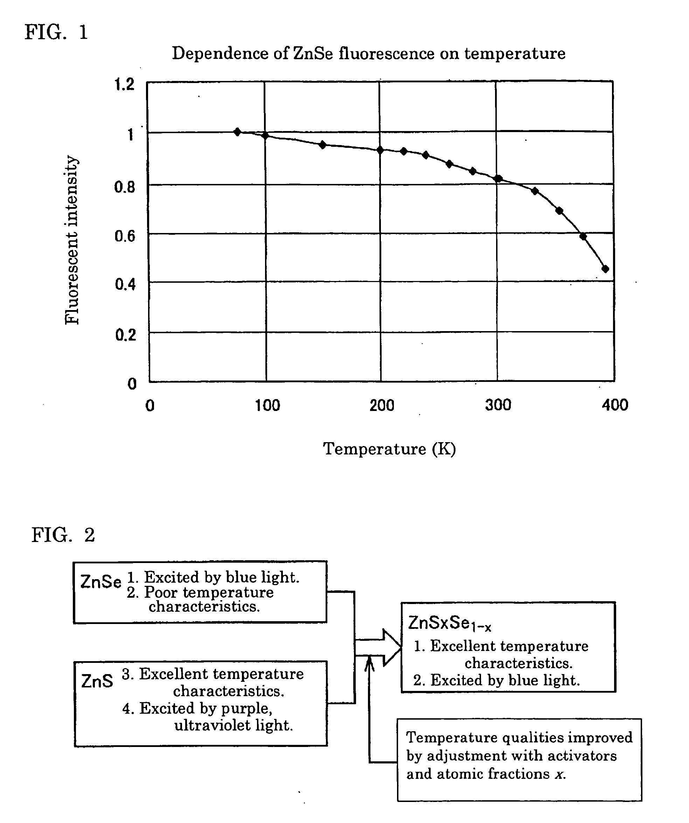

If conventional phosphors are evaluated from these perspectives, then the fact that YAG types are limited to the yellow band means that their excitation-emission properties are inadequate. ZnSe phosphors demonstrate emission that is convenient in terms of synthesizing white light of a color temperature of choice, but the wavelength of the excitation beam is restricted to 485 nm or thereabouts, and in that wavelength band the emission efficiency of an InGaN LED ends up being rather low. Consequently, the combination of wavelengths from YAG and ZnSe phosphors is not necessarily optimal. Moreover, the temperature behavior of ZnSe phosphor was assayed, which indicated, as shown in Fig. 1, that the temperature characteristics of ZnSe phosphor are not necessarily the best. At or around room temperature, ZnSe phosphor already exhibits remarkable temperature quenching, and not only is the efficiency not high, according as the LED temperature changes the proportions of blue and yellow light change, which ends up altering the hue (color temperature, etc.) of the white.

Under the circumstances, then, attention in the present invention was given to ZnS phosphors. ZnSe and ZnS are similar phosphors in which only the Se and S are interchanged. With ZnS, on account of its wider band gap than that of ZnSe, excitation light from violet to ultraviolet would be necessary in order to propose ZnS luminophors. Consequently, ZnS is not usable in white LEDs of the blue-light-excitation type. Nevertheless, ZnS phosphors have superlative temperature characteristics, and thus are widely used as phosphors for electron-beam excitation such as in television cathode-ray tubes. In light of these considerations, as represented in Fig. 2, the concept was hit upon that a phosphor possessing the combined superior features of ZnSe phosphors and ZnS phosphors ought to be realizable with ZnS_{*x*}Se_{*1-x*} (0 < *x* < 1), being a solid solution of ZnSe and ZnS.

It should be understood that while only "ZnSe phosphors" and "ZnS phosphors" have been referred to, in order for ZnSe and ZnS to operate as phosphors, it is necessary to disperse activators and coactivators into the parent material (in this case ZnSe and ZnS). As activators for ZnS luminophors, the Group Ib elements Ag, Cu and Au are known. Likewise, as coactivators, the Group VIIa elements F, Cl, Br and I, as well as the Group IIIa elements Al, In and Ga are known. As far as coactivators are concerned, the phosphor emission behavior does not change much no matter what element is used.

As far as activators are concerned, it is known that the fluorescent wavelength shortens when Ag is used, and lengthens when Cu or Au is used. There is no major difference between Cu and Au. Given these considerations, activators and coactivators were introduced into ZnS_{*x*}Se_{*1-x*} of a variety of S atomic fractions (*x*) to prepare phosphors, and their excitation-emission properties and temperature characteristics were investigated to find out whether they could be exploited in fabricating white LEDs.

### Phosphor Selection

ZnSSe into which iodine was incorporated by the iodine transport method was composed. ZnSSe phosphors were prepared by diffusing Cu or Ag into the ZnSSe within a Zn atmosphere. The results are set forth in the following.

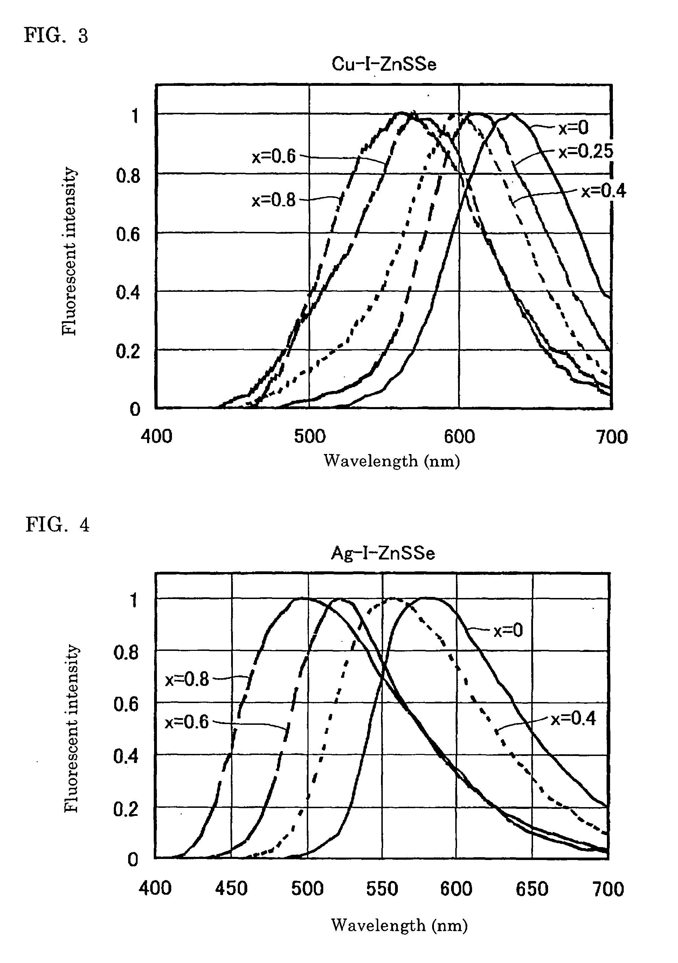

Emission spectra for ZnS_{*x*}Se_{*1-x*} (*x* = 0, 0.25, 0.4, 0.6, 0.8) into which Cu and I were introduced, and emission spectra for ZnS_{*x*}Se_{*1-x*} *(x =* 0, 0.4, 0.6, 0.8) into which Ag and I were introduced are shown respectively in Fig. 3 and Fig. 4. For the measurements, a beam from a He-Cd laser of 325 nm wavelength was employed as the excitation light. In either instance, with increasing S atomic fraction x the fluorescent wavelength is shortened. As to the activators, it is evident from the spectra that with the ZnSSe phosphors in which Ag was employed, the fluorescent wavelength is shorter than with those in which Cu was employed.

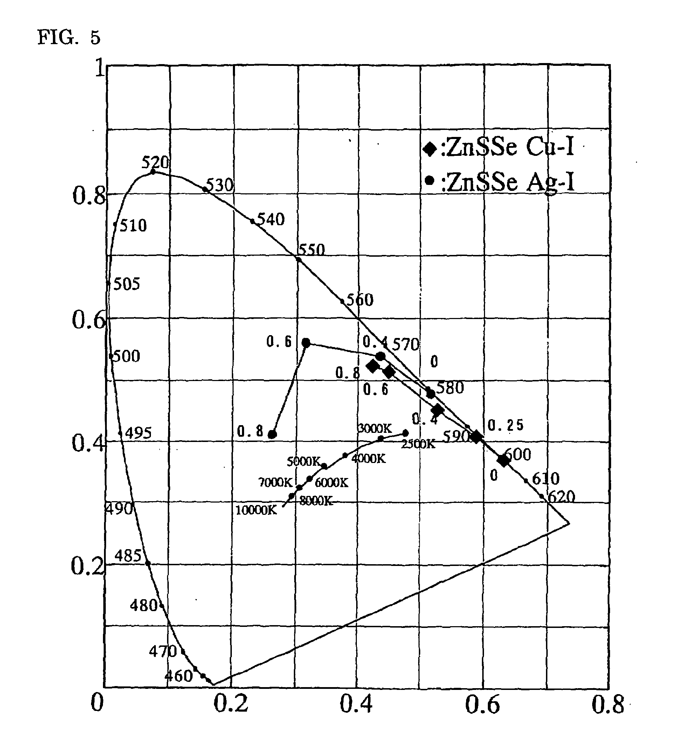

Chromaticities were calculated from the spectra in Figs. 3 and 4 and plotted on the Fig. 5 chromaticity diagram. As will be understood from Fig. 5, these chromaticity coordinates form the complementary colors for violet to blue-green, 380 to 500 nm; therefore, blending these phosphor fluorescences with light of 380 to 500 nm can yield white. The problem remaining was whether the ZnSSe phosphor can be stimulated by the abovementioned visible light. Thus, an excitation spectrum for ZnSSe (change in fluorescent intensity as the excitation wavelength is varied) was measured to find the excitation peak. Therein, a ZnSSe phosphor of 1 mm thickness was used in the measurement.

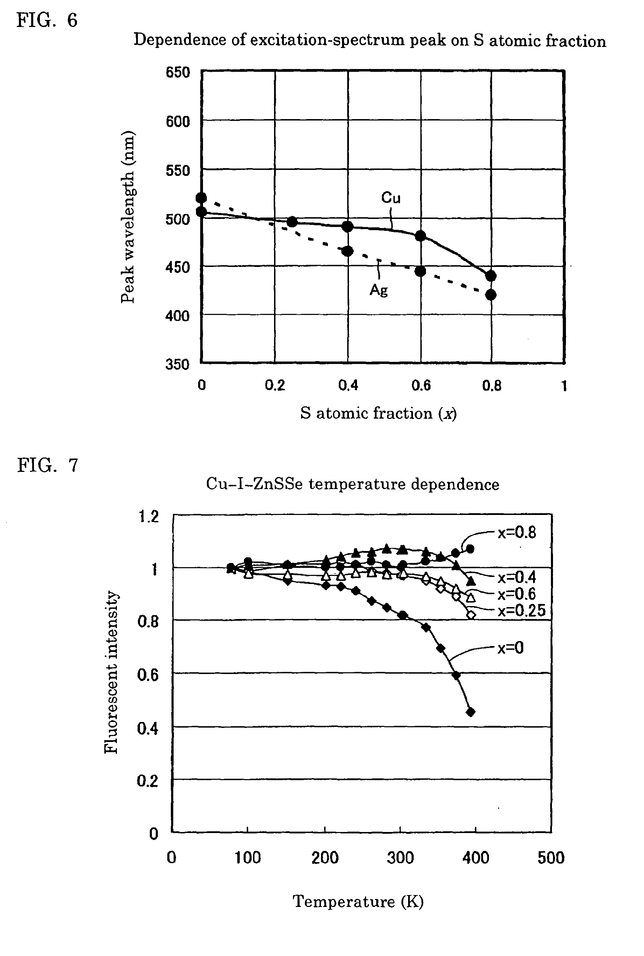

In Fig. 6 the peak wavelengths in the excitation spectrum for ZnS_{*x*}Se_{*1-x*} (*x* = 0, 0.25, 0.4, 0.6, 0.8) into which Cu and I were introduced, and the peak wavelengths in the excitation spectrum for ZnS_{*x*}Se_{*1-x*} *(x =* 0, 0.4, 0.6, 0.8) into which Ag and I were introduced are shown. In either case, when the S atomic fraction is enlarged the peak in the excitation spectrum is shortened in wavelength. Although a measurement was not made on a phosphor in which the S atomic fraction is 1―that is, on ZnS―extrapolating from the data in Fig. 6, it may be inferred that up until the S atomic fraction is about 0.9, the phosphor may be stimulated with visible rather than ultraviolet light.

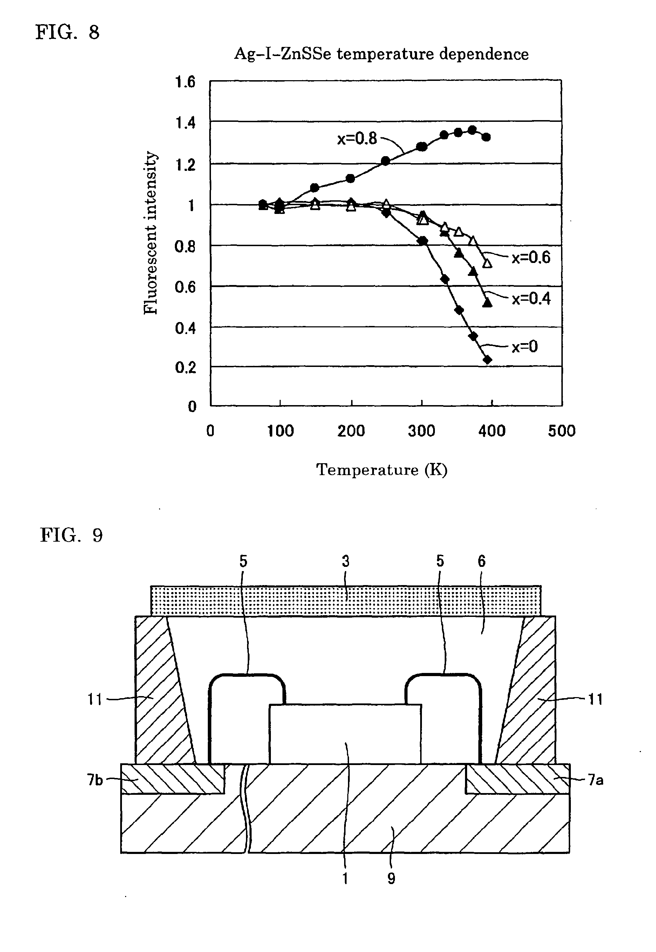

Next the dependence of fluorescent intensity on temperature was measured. The results are arranged together in Figs. 7 and 8. It is evident from Figs. 7 and 8 that rendering the S atomic fraction *x* about 0.2 or more dramatically improves the temperature characteristics by comparison to the case in which the S atomic fraction is zero (ZnSe).

Illuminating the phosphor with excitation rays of the foregoing violet to blue-green of 380 to 500 nm, and mixing together the fluorescence and the excitation rays allows white and the intermediate colors surrounding it (pink, pale green, bluish white, etc.) to be synthesized. In order to produce the white that is industrially most important, however, the combination of excitation rays and phosphor can be narrowed down a little more.

*s1 -* First, the instances in which Cu and Au were employed as activators are examined. In these cases, if the S atomic fraction x were low, the temperature characteristics would suffer, and further, longer-wavelength excitation rays would be necessary. With InGaN LEDs, because the efficiency with which they excite proves to be highest at wavelengths in the vicinity of 400 to 450 nm, they are undesirable to use for longer-wavelength excitation light. Using Zn*S*_{*x*}Se_{*1-x*} (0.5 ≤ *x* ≤ 0.9) for the phosphor and using an LED whose emission spectrum spans wavelengths of 410 to 490 nm for the excitation rays is preferable.

*s2* - Next, the instance in which Ag was employed is considered in the same way, wherein using ZnS_{*x*}Se_{*1-x*} (0.4 *≤ x ≤* 0.5) for the phosphor and using an LED whose emission spectrum spans wavelengths of 410 to 460 nm for the excitation rays is preferable.

The foregoing phosphors may also be employed as the green phosphor and red phosphor for a white LED of the RGB type.

*G* - In cases in which Au or Cu are employed as activators, ZnS_{*x*}Se_{*1-x*} (0.7 ≤ *x* ≤ 0.9) may be utilized for the green phosphor. Likewise, in cases employing Ag as an activator, ZnS_{*x*}Se_{*1-x*} (0.5 ≤ *x* ≤ 0.8) may be utilized. In composing an RGB type of white, ZnSSe phosphors may be used for both the red phosphor and the green phosphor, or for one or the other a different phosphor may equally well be used.

*R* - In turn, as far as red light is concerned, since high-efficiency red LEDs are available, a red LED may be employed instead of a red phosphor. A problem in that case, however, is that since the deterioration rates of blue LEDs and red LEDs are different, the hue of the white will end up varying over time. All told, it would seem that combining slow-to-deteriorate phosphors would be advantageous over blue LEDs as an optical excitation source.

It should be noted that although the activators were dispersed into the foregoing phosphors within a Zn atmosphere, they may equally well be dispersed within for example an Se atmosphere. Nevertheless, empirically there is a likelihood that the fluorescing efficiency of phosphors into which activators have been dispersed within an Se atmosphere will turn out low.

Features of ZnSSe phosphors include, to name examples, the fact that the source materials are modestly priced and that clumplike rather than powdered phosphors can easily be synthesized. Routinely, phosphors have been rendered into powder form, and have been spread onto a glass substrate or have been dispersed into a synthetic polymer. With ZnSSe phosphors, nevertheless, the phosphors can be employed in clump form without making them into a powder, eliminating cost problems. While that is an advantage to using clumplike phosphors, compared with the situation in which a phosphor is dispersed into a synthetic polymer, with a clumplike phosphor, because heat generated inside the phosphor is readily dissipated to the exterior, the phosphor temperature is not liable to rise. Consequently, the lifespan of the white LEDs is prolonged as a result, enabling high-output-power white LEDs to be realized.

### White-Light Emitting Device Configuration

Reference is now made to Fig. 9, a view illustrating the configuration of a white-light emitting device in Embodiment 1 of the present invention. A blue LED 1 is attached to a mounting portion 9 of a lead frame so that their like surfaces are matched. Through wires 5 out of external electrodes 7a, 7b, electric current is conducted into (not-illustrated) chip electrodes on the blue LED 1. A heat-dissipating member 11 made of aluminum is disposed encompassing the blue LED. A transparent polymer 6 into which a diffusant is dispersed is disposed covering the blue LED, and a phosphor plate 3 is arranged atop the transparent polymer 6.

The phosphor 3 is established from *ZnS*_{*x*}*Se*_{*1-x*} of S atomic fraction *x*, and an activator, and is adjusted so as to lead to white light of a predetermined color temperature. Adjusting the composition of and the activator in the phosphor *ZnS*_{*x*}*Se*_{*1-x*} to attain white light of a predetermined color temperature is an important element of the present invention. Furthermore, what with the specific weights for adjustment being small and the breadth of the adjustment being limited, in some cases the emission spectrum of the blue LED is also an object of adjustment.

The blue LED into which current has been fed through the external electrodes 7a, 7b emits light of a blue color, shining the light onto the phosphor 3. The light irradiated from the blue LED 1 is shone onto the phosphor plate 3, and this fluorescent emission material is stimulated to give off fluorescence. Though the rays irradiated from the blue LED 3 illuminate the phosphor plate 3, this does not mean that all are utilized in excitation; some pass through the phosphor plate 3 without contributing to excitation. Consequently, fluorescence of a predetermined wavelength and blue light emitted from the blue LED are combined to create white light of a predetermined color temperature.

Reference is made to Fig. 10, a view representing a white-light emitting device in Embodiment 2 of the present invention. What is different from the white-light emitting device represented in Fig. 9 is that two phosphors are laid out―a first phosphor 3 and a second phosphor 13. The first phosphor 3 is a green phosphor, and is formed for example by a ZnSSe plate (ZnS atomic fraction 0.6). Likewise, the second phosphor 13 is a red phosphor, and is formed for example by ZnSSe crystal (ZnS atomic fraction: 0.25). An RGB-type of white-light emitting device can be configured by the blue LED 1, and the foregoing red phosphor 13 and green phosphor 3.

### Embodiments

### Embodiment 1

The white-light emitting device depicted in Fig. 9 was prepared. At first a ZnSSe crystal was grown using the iodine transport method and subsequently underwent heat treatment within a 1000°C atmosphere in which Zn and Cu vapors were mixed, whereby a ZnS_{0.6}Se_{0.4} crystal of predetermined composition (ZnS atomic fraction 0.6) was prepared. This phosphor corresponds to the rhombic mark for ZnS atomic fraction 0.6 nearby wavelength 570 nm on the chromaticity diagram, and is a yellow-light emitting phosphor. A ZnSSe plate of 250 microns thickness was cut out from the ZnS_{0.6}Se_{0.4} crystal. Both sides of the ZnSSe plate were polished to a mirror-like finish, bringing the thickness down to 200 µm, and the polished plate was sliced into a 3 mm square to produce a ZnS_{0.6}Se_{0.4} phosphor plate.

In addition, a blue LED chip of 450 nm emission wavelength, having an InGaN active layer, was readied. An Ag paste was employed to bond the LED chip onto a chip die (lead-frame mounting portion) 9, as shown in Fig. 9, made of Al. Furthermore, the LED-chip electrodes and the chip-die electrodes were wire-bonded with Au wire. Thereafter, by covering the LED with a transparent synthetic polymer 6, and installing the ZnSSe phosphor plate 3 above the LED, a white-light emitting device was fabricated. Current was passed into the white-light emitting device to cause it to emit light, giving rise to blue light issuing from the LED and yellow fluorescence sent forth by excitation via the blue light, whereby emission of white light of 5000 K color temperature could be produced.

### Embodiment 2

The white-light emitting device depicted in Fig. 10 was prepared. A ZnSSe plate of 250 microns thickness was cut out from a ZnS_{0.6}Se_{0.4} crystal (ZnS atomic fraction 0.6) at first being grown using the iodine transport method, and subsequently undergoing heat treatment within a 1000°C atmosphere in which Zn and Ag vapors were mixed. This phosphor corresponds to the black-dot mark for ZnS atomic fraction 0.6 on the chromaticity diagram, and is a green-light emitting phosphor. Both sides of the ZnSSe plate were polished to a mirror-like finish, bringing the thickness down to 200 microns, and the polished plate was sliced into a 3 mm square to produce a ZnSSe phosphor plate (green phosphor: first phosphor).

In addition, a 400-micron square, 250-micron thick ZnS_{0.25}Se_{0.75} phosphor plate (red phosphor: second phosphor) was prepared from a ZnS_{0.25}Se_{0.75} crystal (ZnS atomic fraction 0.25) that was grown using the iodine transport method and subsequently underwent heat treatment within a 1000°C atmosphere in which Zn and Cu vapors were mixed. This phosphor corresponds to the rhombic mark for ZnS atomic fraction 0.25 on the chromaticity diagram and is a red-light emitting phosphor.

In addition, a blue LED chip of 450 nm emission wavelength, having an InGaN active layer, was readied. An Ag paste was employed to bond the LED chip onto the chip die (mounting portion of a lead frame) 9, as shown in Fig. 10, made of Al, and further the LED-chip electrodes and the chip-die electrodes were wire-bonded with Au wire. In addition, the second phosphor was also bonded to the chip die.

Thereafter, by covering the LED with a transparent synthetic polymer 6 into which a diffusant was dispersed, and then installing the ZnSSe phosphor plate as the first phosphor 3 above the LED, an RGB type of white-light emitting device was fabricated. By passing current into the white-light emitting device to cause it to emit light, emission of white light of 5000 K color temperature could be produced.

A white-light emitting device of the present invention, by utilizing fluorescing materials such as phosphors, makes it possible stably to produce, with good efficiency and without altering of hue relative to changes in temperature, white light of a color temperature of choice, and therefore is expected to find wide-ranging uses in commercial applications and industrial applications in which great importance is attached to hue.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A white-light emitting device furnished with an LED (light-emitting diode); and a phosphor ZnS_{*x*}Se_{*1-x*} (0 < *x* < 1) that contains at least one activator among Cu, Ag and Au, and that sends forth light when stimulated by rays irradiated from said LED.

2. A white-light emitting device as set forth in claim 1, wherein said phosphor is ZnS_{*x*}Se_{*1*}₋_{*x*} (0.2 *≤ x ≤* 0.9), and sends forth light when stimulated by rays in a range of wavelengths 380 nm to 500 nm irradiated from said LED.

3. A white-light emitting device as set forth in claim 1 or 2, wherein said phosphor ZnS_{*x*}Se_{*1-x*} (0 < *x* < 1) further contains at least one coactivator among Cl, Br, I, Al, In and Ga.

4. A white-light emitting device as set forth in any of claims 1 through 3, wherein said phosphor ZnS_{*x*}Se_{*1-x*} (0 < *x* < 1) is in either a clumplike or powdered form.

5. A white-light emitting device as set forth in any of claims 1 through 4, wherein said phosphor is ZnS_{*x*}Se_{*1-x*} (0.5 ≤ *x ≤* 0.9), contains at least one of the activators Au and Cu, and sends forth light when stimulated by rays in a range of wavelengths 410 nm to 490 nm irradiated from said LED.

6. A white-light emitting device as set forth in any of claims 1 through 4, wherein said phosphor is ZnS_{*x*}Se_{*1-x*} (0.4 ≤ *x* ≤ 0.5), contains the activator Ag, and sends forth light when stimulated by rays in a range of wavelengths 410 nm to 490 nm irradiated from said LED.

7. A white-light emitting device as set forth in any of claims 1 through 4, including, as said phosphor ZnS_{*x*}Se_{*1-x*} (0 < *x* < 1), at least one of a phosphor ZnS_{*x*}Se_{*1-x*} (0.7 ≤ *x* ≤ 0.9) containing at least one of the activators Au and Cu, and a phosphor ZnS_{*x*}Se_{*1-x*} (0.5 ≤ *x* ≤ 0.8) containing the activator Ag; and further furnished with said LED irradiating rays in a range of wavelengths 410 nm to 490 nm, and a separate LED that irradiates red light.

8. A white-light emitting device as set forth in any of claims 1 through 4, including, as said phosphor ZnS_{*x*}Se_{*1-x*} (0 < *x* < 1), at least one of a phosphor ZnS_{*x*}Se_{*1-x*} (0.7 ≤ *x ≤* 0.9) containing at least one of the activators Au and Cu, and a phosphor ZnS_{*x*}Se_{*1-x*} (0.5 *≤ x ≤* 0.8) containing the activator Ag; and further furnished with a separate phosphor that sends forth light of wavelength longer than that from said phosphor; wherein both said phosphors send forth light when stimulated by rays in a range of wavelengths 410 nm to 490 nm irradiated from said LED.

9. A white-light emitting device as set forth in any of claims 1 through 4, including, as said phosphor ZnS_{*x*}Se_{*1-x*} (0 < *x* < 1), at least one of a phosphor ZnSₓSe_{*1-x*} (0.7 ≤ *x ≤* 0.9) containing at least one of the activators Au and Cu, and a phosphor ZnS_{*x*}Se_{*1-x*} (0.5 ≤ *x ≤* 0.8) containing the activator Ag; and further furnished with, as a separate phosphor, ZnS_{*x*}*Se*_{*1-x*} (0.2 ≤ *x ≤* 0.4) containing at least one of the activators Au and Cu; wherein both said phosphors send forth light when stimulated by rays in a range of wavelengths 410 nm to 490 nm irradiated from said LED.

10. A white-light emitting device as set forth in any of claims 1 through 4, furnished with, as said phosphor ZnS_{*x*}Se_{*1-x*}(0 < *x* < 1), a phosphor ZnS_{*x*}Se_{*1-x*} (0.2 ≤ *x* ≤ 0.4) containing at least one of the activators Au and Cu; and further furnished with a separate phosphor that sends forth green light; wherein both said phosphors send forth light when stimulated by rays in a range of wavelengths 410 nm to 490 nm irradiated from said LED.

11. A white-light emitting device as set forth in any of claims 1 through 10, wherein said phosphor ZnS_{*x*}Se_{*1-x*} (0 *< x* < 1) is in clumplike form and is mounted on, so as to mate surfaces with, either said LED or a heat-dissipating member furnished in the white-light emitting device.

12. A white-light emitting device as set forth in any of claims 1 through 11, wherein an InGaN LED is utilized for said LED.

13. A white-light emitting device as set forth in any of claims 1 through 12, wherein said phosphor ZnS_{*x*}Se_{*1-x*} (0 < *x <* 1) is heat-treated in an atmosphere containing Zn vapor.

14. A phosphor-manufacturing method including: a step of forming a phosphor ZnS_{*x*}Se_{*1-x*} (0 < *x* < 1) containing at least one among coactivators Cl, Br, I, Al, In and Ga; and a step of carrying out a process, within a vaporous mixture of a vapor of at least one of activators Au, Cu and Ag and a vapor of Zn, of heating said coactivator-containing phosphor ZnS_{*x*}Se_{*1-x*} (0 *< x* < 1) to the vaporous mixture temperature.

15. A phosphor manufactured by the phosphor-manufacturing method set forth in claim 14.

16. A white-light emitting device including a phosphor manufactured by the phosphor-manufacturing method set forth in claim 14.
